# EUROPEAN PATENT APPLICATION

(11) **EP 3 910 276 A1**
(43) Date of publication of application: **17.11.2021**
(21) Application number: 20174427.3
(22) Date of filing: 13.05.2020
(51) Int. Cl.: F28F 13/00

(54) **HEAT EXCHANGER MATERIAL AND HEAT EXCHANGER FOR CRYOGENIC COOLING SYSTEMS, AND A SYSTEM**

(71) Applicant: Bluefors Oy, 00370 Helsinki (FI)
(72) Inventor: Salmela, Anssi, 00670 Helsinki (FI)
(74) Representative: Papula Oy

(57) **Abstract**

Heat exchanger material for use in heat exchangers of cryogenic cooling systems, comprises solid material rendered into its final form in an additive manufacturing process. The material has a surface-to-volume ratio of at least 10⁵ 1/m.

## Description

### FIELD OF THE INVENTION

The invention is related to the technical field of heat exchangers that are use in cryogenic cooling systems to exchange thermal energy at very low temperatures. In particular the invention is related to overcoming the difficulties in making thermal energy transfer between a liquid cryogen and an adjacent solid structure.

### BACKGROUND OF THE INVENTION

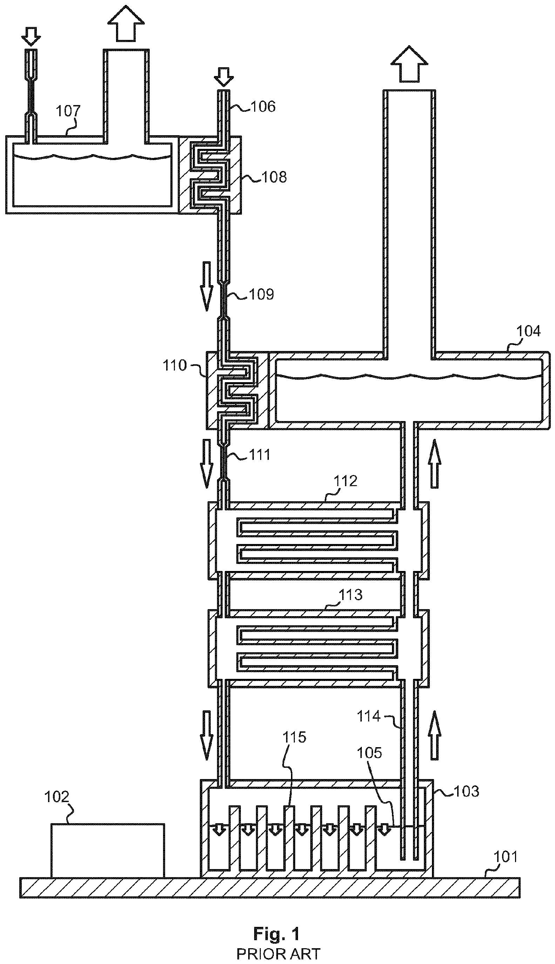

Cryogenic cooling systems use heat exchangers for making thermal energy flow from a warmer part or substance to a colder part or substance. Fig. 1 is a simplified cross-sectional illustration of a dilution refrigerator, which serves as an example of a cooling system where various heat exchangers are used. The ultimate aim is to make a target region or cold plate 101 as cold as possible for cooling an object 102 coupled thereto; the object 102 may be for example a scientific sample to be examined or a quantum electronic circuit to be utilized for quantum computing.

Two primary parts of the dilution refrigerator are the mixing chamber 103 and the still 104, of which the mixing chamber 103 is attached to the cold plate 101. A mixture of the helium isotopes He-3 and He-4 is circulated within the dilution refrigerator. Its cooling effect is based on the spontaneous phase separation into a He-3-rich phase (concentrated phase) and a He-3-poor phase (the dilute phase) when cooled under about 870 mK. The process of He-3 moving through the phase boundary into the dilute phase is endothermic. The phase boundary 105 is located inside the mixing chamber 103, so the continuous "evaporation" of He-3 from the concentrated phase into the dilute phase causes the mixing chamber 103 and everything thermally coupled to it to cool down to temperatures of just some millikelvins in optimal conditions.

A supply line 106 allows a pumping system (not shown in fig. 1) to supply pre-cooled gaseous He-3 through a series of heat exchangers into the mixing chamber 103. In the exemplary system shown in fig. 1 there is a so-called 1K pot 107 and an associated heat exchanger 108 for liquefying the incoming He-3 and for removing its heat of condensation. The liquid He-3 flows through a flow impedance 109 into another heat exchanger 110 that is thermally coupled to the still 104. A further flow impedance 111 conducts the liquid He-3 to a series of further heat exchangers, of which two are shown in fig. 1 as 112 and 113. In these the incoming liquid He-3 is cooled by cold dilute He-3 flowing out of the mixing chamber 103 through line 114 towards the still 104. The number, construction, and location of heat exchangers may vary considerably, so fig. 1 should be considered as a schematic example only.

In all heat exchangers described above the aim is to cool down the incoming He-3 by making thermal energy flow to a colder substance, which is the vacuum-pumped He-4 in the 1K pot 107, the cold helium mixture in the still 104, or the cold dilute He-3 flowing out of the mixing chamber 103 in the heat exchangers 112 and 113. A solid barrier, typically of a metal or other material that conducts heat effectively at extremely low temperatures, is needed in all these heat exchangers to keep the two substances from getting mixed with each other. Also the mixing chamber 103 acts as a heat exchanger, because it transfers thermal energy from the solid structures of itself and the cold plate 101 into the helium mixture.

Typical materials used for those solid structures of the system that should conduct heat effectively at extremely low temperatures include copper and silver. Specific attention needs to be paid to the purity, grain size, and regularity in the crystal structure of the metal, because all these have an effect on its thermal conductivity and these effects tend to become more prominent at extremely low temperatures.

The mixing chamber 103 is shown to comprise internal, vertically extending metal structures 115 in fig. 1. Their purpose is to offer as large cross section as possible of solid, thermally conducting material between the phase boundary 105 (where the actual cooling effect occurs) and the base of the mixing chamber 103, which is coupled to the cold plate 101.

A problem often encountered with heat exchangers in cryogenically cooled systems is interfacial thermal resistance, also called the Kapitza resistance. It means the inherent difficulty of making thermal-energy-carrying phonons cross the border between two materials, in particular between liquid helium and a metal. Kapitza resistance is a major problem in the lowest temperatures, like under 100 mK.

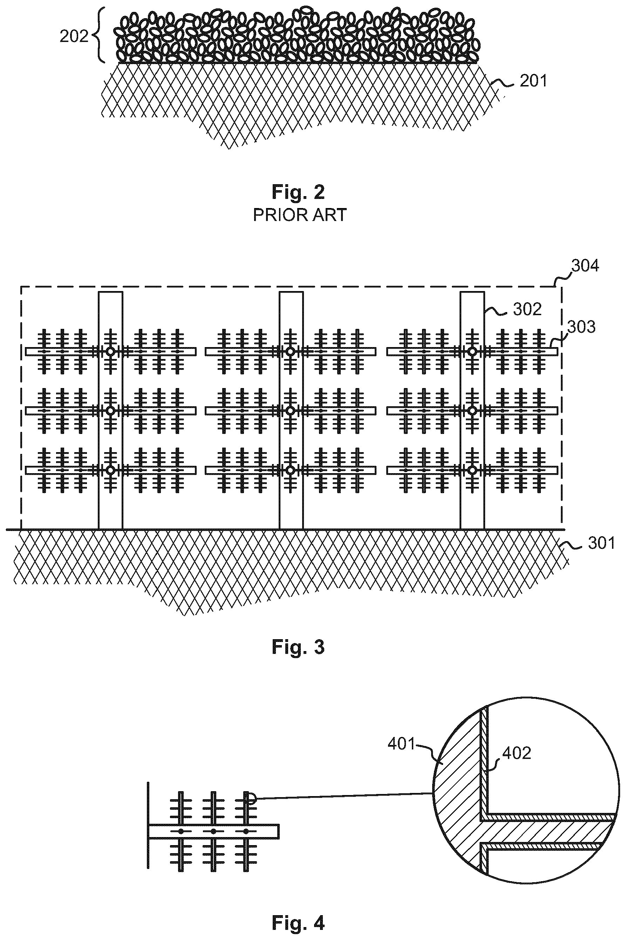

Known ways to fight the disadvantageous effects of Kapitza resistance involve increasing the surface area available for transferring the heat between the two materials, and using multi-faceted surfaces in which a large plurality of differently oriented surface facets are available. Both aims can be achieved by using sintered surfaces. Fig. 2 illustrates schematically a solid metal structure 201, a surface of which is covered with a layer 202 of sintered material. The sintered material may be for example silver, and the layer 202 can be produced in a known way that involves heating silver powder close to its melting point under considerable pressure. The layer 202 of sintered material is porous by nature, because it consists of small metal granules partly bonded together, so using such a layer on a metal surface exposed to a cold cryogen greatly multiplies the surface area available for heat transfer and produces an almost infinite number of differently oriented surface facets.

Despite its advantageous features the use of sintered surface layers involves also drawbacks. Sintering as a manufacturing process involves certain stochasticity, because the way in which the miniature material granules behave in the process cannot be completely controlled to the smallest detail. This means that even if two similar workpieces come out of the same sintering process, their performance in actual use may be different. In a delicate device such as a dilution refrigerator the variations in heat exchanger performance may mean that one unit may not achieve the same lowest possible temperature as the other, and/or that different units must be operated in slightly different ways in order to reach optimal results.

Another drawback of the sintered surface layer is its inherently low thermal conductivity compared to corresponding solid metal. Assuming that the sintered surface is exposed to a liquid cryogen that should be cooled down, once the thermal energy has been captured from the liquid into the sintered substance it should be conducted towards the solid base material (reference 201 in fig. 2) as efficiently as possible. Similarly in the other direction, if the sintered surface is used to transfer heat into a surrounding liquid cryogen, that heat should be conducted from the solid base material 201 into the granular matrix of the sintered surface layer 202 as efficiently as possible before it can be transferred further across the solid/liquid interface. The low thermal conductivity across the sintered material means that it is typically not advantageous to use sintered layers of more than just a few millimetres thick.

### SUMMARY

An objective is to present a heat exchanger material, a heat exchanger for a cryogenic cooling system, and a cryogenic cooling system in which the problems related to Kapitza resistance are solved more effectively than in prior art solutions. Another objective is that the heat exchanger material and the heat exchanger enable transferring thermal energy between cold liquid cryogen and a solid material with high efficiency. A further objective is that the heat exchanger and the cryogenic cooling system are easy to manufacture in a large variety of sizes and versions.

These and further advantageous objectives are achieved by using an additive manufacturing method to produce a meandering surface structure for the heat exchanger.

According to a first aspect there is provided a heat exchanger material for use in heat exchangers of cryogenic cooling systems. The material comprises solid material rendered into its final form in an additive manufacturing process. The material has a surface-to-volume ratio of at least 10⁵ 1/m (ten to the fifth power in units of one per meter).

According to an embodiment the material comprises a plurality of extended thermal conduction paths in the form of regularly shaped portions of said solid material that extend through a majority of a thickness of the material and occur in a repetitive pattern throughout a layer of said material. This involves the advantage that good and well-defined overall thermal conductivity can be maintained through even a relatively thick layer of the material.

According to an embodiment the material has a recursive surface structure in which surface features of first characteristic dimension are covered with similar surface features of second characteristic dimension smaller than said first characteristic dimension. This involves the advantage that the required large surface-to-volume ratio can be achieved by increasing the degree of recursion sufficiently.

According to an embodiment said material defines a recursive spatial form in which first spatial features of a piece of said material have a first characteristic dimension and consist of second, similar spatial features of a second characteristic dimension smaller than said first characteristic dimension. This involves the advantage that the required large surface-to-volume ratio can be achieved by increasing the degree of recursion sufficiently.

According to an embodiment said at least one surface of the material comprises a maze defined by a plurality of mesh-formed or matrix-formed layers stacked on top of a solid surface of said material, at least some of said mesh-formed or matrix-formed layers having solid stretches that bridge openings in a respective adjacent mesh-formed or matrix-formed layer. This involves the advantage that the required large surface-to-volume ratio can be achieved by adding a sufficient number of layers.

According to an embodiment said solid material comprises at least one of: copper, silver, plastic. This involves the advantage that a good combination of thermal conductivity and applicability to additive manufacturing methods can be achieved.

According to a second aspect there is provided a heat exchanger for transferring thermal energy to or from a liquid cryogen. The heat exchanger comprises a surface of a liquid cryogen space and, as a part of said surface, solid material rendered into its final form in an additive manufacturing process. At least a surface layer of said final form of the material has a surface-to-volume ratio of at least 10⁵ 1/m.

According to an embodiment the heat exchanger comprises a base structure that limits said liquid cryogen space and a multitude of protrusions extending from said base structure into said liquid cryogen space, so that said surface of said liquid cryogen space comprises surfaces of said protrusions. This involves the advantage that structural stability can be provided by the base structure while the required large surface-to-volume ratio can be achieved with the surfaces of said protrusions.

According to an embodiment said multitude of protrusions constitute a recursively repeating branching structure based on each individual protrusion of at least said majority of protrusions. This involves the advantage that the required large surface-to-volume ratio can be achieved by increasing the degree of recursion sufficiently.

According to an embodiment said solid material comprises a maze defined by layered meshes or particle matrices on said surface of the base structure. This involves the advantage that the required large surface-to-volume ratio can be achieved by adding a sufficient number of layers.

According to an embodiment said maze is defined by layers of mesh or particle matrix on top of each other with a lateral shift between consecutive ones of said layers of mesh or particle matrix. This involves the advantage that the required large surface-to-volume ratio can be achieved by adding a sufficient number of layers.

According to an embodiment the heat exchanger comprises a liquid cryogen vessel divided into at least two separate liquid cryogen spaces by a partition wall, so that said surface of said liquid cryogen space comprises at least one surface of said partition wall. This involves the advantage that very efficient transfer of heat between two flows of liquid cryogen can be achieved.

According to a third aspect there is provided a cryogenic cooling system comprising a flow path for a liquid cryogen and - along said flow path - at least one heat exchanger for transferring thermal energy to or from a liquid cryogen flowing through said flow path. Said at least one heat exchanger comprises solid material rendered into its final form in an additive manufacturing process, at least a surface layer of said final form of the material having a surface-to-volume ratio of at least 10⁵ 1/m. Said solid material is exposed to liquid cryogen on said flow path.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**Figure 1** is a cross-sectional view of a dilution refrigerator,
**figure 2** is a schematic cross-sectional view of a metal structure covered with a sintered layer,
**figure 3** is a schematic view of a heat exchanger structure manufactured with an additive manufacturing method,
**figure 4** shows an optional detail of the structure shown in fig. 3,
**figure 5** illustrates the construction of a layered structure,
**figure 6** illustrates a surface covered with a layered structure,
**figure 7** illustrates the construction of another layered structure,
**figure 8** illustrates an optional detail of the construction shown in fig. 7,
**figure 9** illustrates another optional detail of the construction shown in fig. 7,
**figure 10** illustrates another optional detail of the construction shown in fig. 7,
**figure 11** illustrates a surface covered with a layered structure,
**figure 12** illustrates a heat exchanger and details of its structure,
**figure 13** illustrates a heat exchanger,
**figure 14** illustrates a heat exchanger,
**figure 15** illustrates a heat exchanger,
**figure 16** illustrates a heat exchanger, and
**figure 17** illustrates a heat exchanger and a detail of its structure.

### DETAILED DESCRIPTION

Additive manufacturing is a general concept covering a variety of manufacturing methods that share the principle of joining or solidifying material under computer control to create a solid, three-dimensional object. Additive manufacturing is often casually referred to as 3D printing. Examples of additive manufacturing methods include but are not limited to fused deposition modeling, stereolithography, selective laser sintering, electron beam melting, inkjet 3D printing, and liquid additive manufacturing.

A known advantage of additive manufacturing is that it can be used to create three-dimensional shapes that would be difficult or impossible to manufacture with more conventional manufacturing methods. Examples of such three-dimensional shapes include but are not limited to solid parts with channels or voids going through them in complicated shapes; hollow solid parts that may have other, smaller solid parts therein; or complicated protrusions that protrude out of a surface and comprise a plurality of overhang portions that delimit (at least partially) covered voids.

Materials that can be used in additive manufacturing include for example a large variety of polymers, but also metals as well as composites of two or more basic materials.

A complicated three-dimensional shape may have a large surface-to-volume ratio. As an example taken from prior art, a sintered surface layer like that in fig. 2 can be considered. Each small grain of silver or other sintered material has a certain surface area. The grains constitute an irregular, three-dimensional, interlinked array that leaves a relatively large proportion of the total surface area exposed to the network of voids within the array. The surface-to-volume ratio of sintered silver of the kind used in known cryogenic heat exchangers may be in the order of 10⁷ 1/m, where the unit 1/m is a reduced form of square meters over cubic meters.

An important novel aspect presented herein is that the ability to produce complicated shapes with additive manufacturing can be utilized to produce shapes with a surface-to-volume ratio large enough for use in cryogenic heat exchangers. We may first consider the production of a material per se, without first taking any more detailed position concerning how the material is actually used in the structure of a heat exchanger.

The heat exchanger material considered here is meant for use in cryogenic cooling systems. The intended use already places some requirements to the material. First, it must retain its advantageous properties in the low temperatures that will be encountered in cryogenic cooling. This may mean anything from the relatively modest cooling with liquid nitrogen (around 77 K) down to the most extreme cooling achieved with dilution refrigerators (only some millikelvins). The material should have the necessary structural strength so that it does not unintendedly deform or disintegrate under the influence of forces that routinely occur when cryogenic cooling systems are handled (for example assembled and disassembled) and when its parts are subjected to pressure differences of various kinds. The material should have sufficient conductivity of heat, although the advantageous characteristics of certain shapes that can be created with additive manufacturing may have the somewhat surprising effect that lower thermal conductivity of the actual bulk of the material may be accepted, compared to shapes that were manufactured with more conventional methods. In its final form, examining the surface of the material at microscopic level, the material should offer an interface to a liquid cryogen at which the heat-carrying phonons may cross without too much scattering. Additionally, since cryogenic cooling systems frequently involve operation in vacuum, the material should not be prone to sublimation and should show a very low rate of spontaneous outgassing.

The material comprises solid material rendered into its final form in an additive manufacturing process. This may mean that a complete structural part of the heat exchanger is made from scratch using solely the additive manufacturing method (or a plurality of additive manufacturing methods), or that the material comprises one or more portions made with other manufacturing methods but augmented with something that was produced with the additive manufacturing method. As an example of the latter, the material may comprise a structural support layer that was produced with some other method and was thereafter at least partly covered with a surface layer made with an additive manufacturing method.

As an important additional aspect, the material has a surface-to-volume ratio of at least 10⁵ 1/m. The large surface-to-volume ratio is key to the efficient transfer of phonons between a liquid cryogen and the part of the heat exchanger that comprises the material described here.

Another advantageous feature, although not as mandatory as the large surface-to-volume ratio, is the provision of a plurality of extended thermal conduction paths in the form of regularly shaped portions of the solid material that extend through a majority of a thickness of the material. Such regularly shaped portions may occur in a repetitive pattern throughout a layer of the material. The advantage of such extended thermal conduction paths can be considered by briefly considering again the sintered layer shown in fig. 2. The inherently stochastic nature of sintering as a manufacturing method means that any continuous path of thermal conduction through the thickness of the sintered material has a very complicated and irregular shape, from one grain to the other and the other, before reaching the surface of the solid material 201. If such complicated, irregularly shaped, and highly meandering thermal conduction paths could be replaced with more regular ones, the bulk thermal conduction through the sintered layer (or whatever would be used in place of it) could be significantly improved. The performance of the structure in exchanging heat could also be made more predictable and repeatable, instead of having to accept the relatively large unit-to-unit variation typical to sintered heat exchangers.

Various approaches can be taken to creating the large surface-to-volume ratio and possibly also the regular, extended thermal conduction paths. One such approach is illustrated schematically in fig. 3. Here the so-called fractal principle is employed. The material has a recursive surface structure, in which surface features of first characteristic dimension are covered with similar surface features of second characteristic dimension, which is smaller than the first characteristic dimension.

Fig. 3 shows a somewhat simplified example for the purpose of graphical clarity. At the bottom is a solid structure 301, such as a metal or plastic plate for example. The solid structure 301 may have been produced with an additive manufacturing method, or it may be produced with some other means. The surface features of first characteristic dimension are pegs that extend into a direction perpendicular to the surface of the solid structure 301; see peg 302 as an example. Each peg has its own surface covered with smaller pegs that extend into a direction perpendicular to the surface of the peg 302; see smaller peg 303 as an example. Each of these in turn has its own surface covered with even smaller pegs extending into directions perpendicular to the surface, and so on.

Using an additive manufacturing method allows producing this kind of recursive surface structures despite their inherent complicatedness. The repeated branching of pegs into smaller pegs in this recursive surface structure, or indeed any recursive repetition of smaller features covering larger similar features, can be continued down to as small details as allowed by the spatial resolution of the additive manufacturing method used.

The exact form of the recursive surface structure can be selected so that it fills the available volume 304 much more tightly than is reasonable to graphically show in fig. 3, which in turn allows reaching the required large surface-to-volume ratios. In fig. 3 the surface-to-volume ratio would be calculated by calculating the combined surface are of all the pegs, from the largest to the smallest ones, and dividing it by the volume 304 that is filled by the recursive surface structure.

If the recursive surface structure is based on "trees", i.e. protrusions that branch into smaller protrusions that in turn branch into even smaller protrusions etc. like in fig. 3, the "trunks" of the trees constitute a plurality of extended thermal conduction paths in the form of regularly shaped portions of the solid material. They extend through at least a majority of a thickness of the recursive surface structure and occur in a repetitive pattern throughout the layer constituted by the recursive surface structure.

The surface features of first characteristic dimension and those with further, consecutively smaller characteristic dimensions may be made from one material in the additive manufacturing method. Alternatively, two or more materials can be used. Fig. 4 shows an example of how a first material 401 can be used to produce the actual surface features (the pegs of various dimensions) and how a second material 402 can be used to cover their surface with a layer that improves the coupling of phonons between a liquid cryogen and the first material 401. More than two materials could be used, either so that there are more than one material of which the actual surface features are made or so that there are more than one material of which the coating layer is formed.

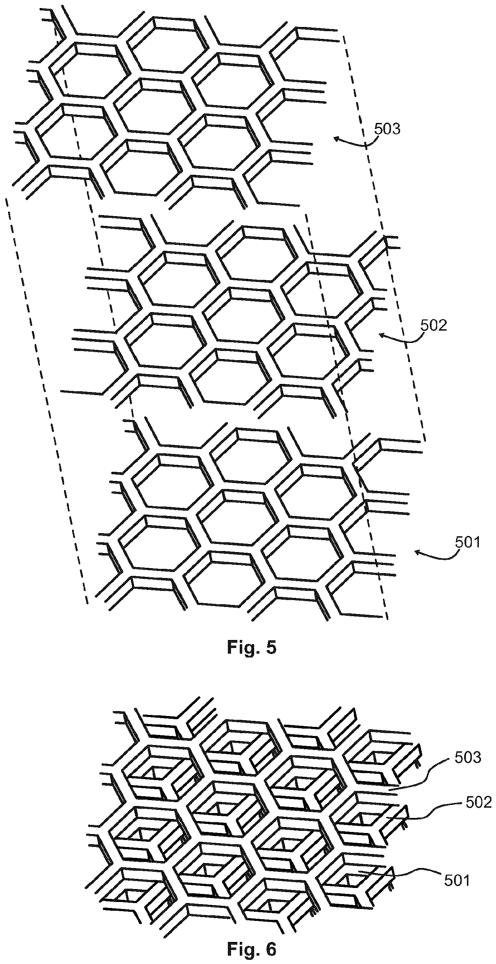

Figs. 5 and 6 illustrate another approach to creating a large surface-to-volume ratio and regular, extended thermal conduction paths. According to this approach, at least one surface of the heat exchanger material comprises a maze defined by a plurality of mesh-formed layers stacked on top of a solid surface of the material. Fig. 5 shows an example of three mesh-formed layers 501, 502, and 503 in an exploded view, and fig. 6 shows how the surface of the heat exchanger material may look like in reality. The lowest mesh-formed layer 501 can be produced onto a solid surface of a supporting structure, such as a metal plate or foil or plastic wall for example. The next mesh-formed layer 502 can be formed directly on top of the first mesh-formed layer 501, however so that the second mesh-formed layer 502 has solid stretches that bridge openings in the first mesh-formed layer. In the example of figs. 5 and 6 this is accomplished with a lateral shift between the first and second mesh-formed layers 501 and 502: each three-branch crossing in the second mesh-formed layer 502 comes next to the center point of a respective hexagonal opening in the first mesh-formed layer 501. A similar effect could be achieved by rotating the second mesh-formed layer 502 with respect to the orientation of the first mesh-formed layer 501, and/or by scaling the second mesh-formed layer 502 to a different size of the openings compared to the first mesh-formed layer 501.

The third mesh-formed layer 503 may again be produced directly on top of the second mesh-formed layer 502, with a lateral shift and/or rotation and/or scaling so that solid stretches in the third mesh-formed layer 503 bridge openings in the second mesh-formed layer 502. In the embodiment of figs. 5 and 6 the third mesh-formed layer 503 coincides in the lateral direction with the first mesh-formed layer 501. By producing more and more mesh layers of this kind on top of each other, alternating between the lateral placement of the first and second mesh layers 501 and 502, one may build a regular structure with a very high surface-to-volume ratio. At every second three-branch crossing, the solid portions of all mesh-formed layers coincide to form a direct, linear, vertical connection through all mesh-formed layers down to the very surface onto which the first mesh-formed layer was produced. These connections constitute a plurality of extended thermal conduction paths in the form of regularly shaped portions of solid material that extend through a majority of the (or here: through the whole) thickness of the maze and occur in a repetitive pattern (i.e. at every second three-branch crossing) throughout the lateral extent of the maze.

The hexagonal form of the mesh-formed layers shown in figs. 5 and 6 is only an example. Other polygonal forms could be used, at least partly curved forms could be used in place of polygons, and consecutive mesh layers need not be of the same form.

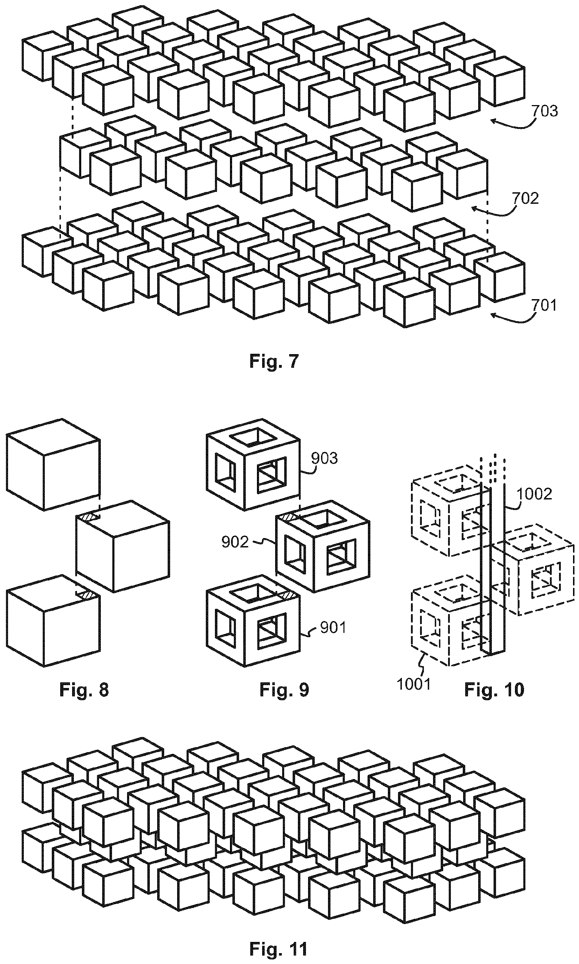

Figs. 7 to 11 illustrate a further approach to creating a large surface-to-volume ratio and regular, extended thermal conduction paths. This approach is closely related to that of figs. 5 and 6, but instead of mesh-formed layers the maze on at least one surface of the material is defined by a plurality of matrix-formed layers. Three matrix-formed layers 701, 702, and 703 are considered here as an example, but just as with the mesh-formed layers of figs. 5 and 6, there may be any number of layers.

Cubes are considered here as an example of volume elements of which each matrix-formed layer 701, 702, and 703 is formed, but other forms could be used quite as well. Here it should be noted that while a matrix-formed layer of separate volume elements would not constitute an entity that could be handled as such, the separate layers are shown in the exploded views of figs. 7, 8, and 9 only in order to make it easier to understand the idea. In the manufacturing process each matrix-formed layer would be formed directly on top of the preceding layer (just like the mesh layers of figs. 5 and 6), so that the preceding layer constitutes the necessary support structure for making the separate volume elements appear as a further matrix-formed layer.

Fig. 8 illustrates in detail an example of how the consecutive layers may be laterally shifted, so that the volume elements of the subsequent layer constitute solid stretches that bridge openings in the previous layer. Fig. 9 illustrates an example how using more complicated forms for the volume elements may help to greatly increase the surface to volume ratio; here the volume elements 901, 902, and 903 are at least partly hollow with openings therethrough.

Fig. 10 illustrates an example of how the overlapping portions of volume elements in consecutive layers may form a plurality of extended thermal conduction paths in the form of regularly shaped portions of solid material. If the lowest volume element 1001 in fig. 10 is on a solid surface, such as a planar metal or plastic surface for example, the overlapping corner portions of the volume elements form a square shaft 1002, the lower end of which is fixed to said solid surface. The conceptual square shaft 1002 extends through at least a majority of a thickness of the maze made of the matrix-formed layers (actually through its whole thickness, if the regularity of the maze is maintained throughout its thickness). Such shaft-formed, extended thermal conduction paths occur in a repetitive pattern throughout the whole maze, at every overlapping corner of the cube-formed volume elements.

Fig. 11 shows schematically how a small portion of three matrix-formed layers made of cube-formed volume elements could look like on a surface. The volume of the maze is the overall volume of all matrix-formed layers combined; the surface is the sum of the exposed surface portions of every volume element in the maze. By making the volume elements small enough, and by providing enough layers in the maze, almost arbitrarily large surface-to-volume ratios can be produced.

In figs. 3 to 11 it was assumed that the heat exchanger material exhibits a certain surface structure. In other words, there is a more or less solid surface, on top of which there are for example an array of recursive structures (see figs. 3 and 4) or a maze of mesh-formed or matrix-formed layers (see figs. 5 to 11). This kind of a solution can be used for example in those parts of a cryogenic cooling system in which the immediate aim is to cool a solid structure. With reference to fig. 1, for example the mixing chamber 103 could have one or more of its interior surfaces covered with a surface structure of such kind. The surface structure would then ensure efficient transfer of heat from the mixing chamber walls, and ultimately from the cold plate 101 and the object 102 to be cooled to the helium mixture inside the mixing chamber 103. If the surface structure covers the bottom of the mixing chamber 103, and if the extended thermal conduction paths formed as a part thereof are long enough, they can be used to even replace the conventional vertically extending metal structures 115 that have been used.

Additionally or alternatively, the heat exchanger material may be of the kind in which the material itself defines a recursive spatial form. This means that certain first spatial features of a piece of the material have a first characteristic dimension and consist of second, similar spatial features of a second characteristic dimension, which second characteristic dimension is smaller than the first characteristic dimension.

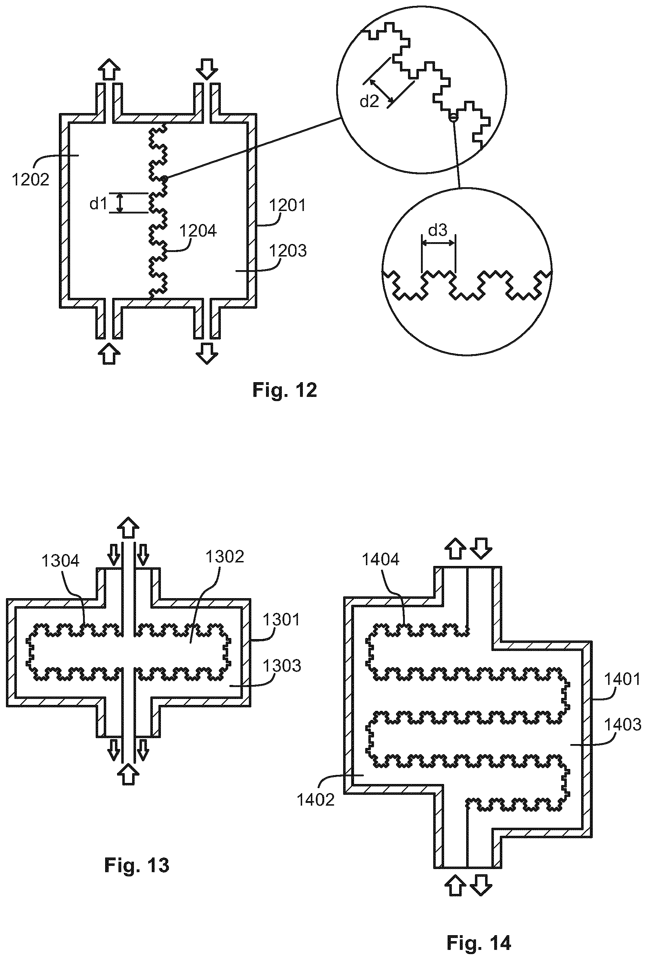

As an example the heat exchanger 1201 of fig. 12 can be considered. Heat exchangers like that in fig. 12 may be meant for transferring thermal energy to or from a liquid cryogen. In the special case of fig. 12 the heat exchanger 1201 is meant for transferring thermal energy to and from a liquid cryogen: it defines two liquid cryogen spaces 1202 and 1203, of which the left liquid cryogen space 1202 is meant for upwards flowing liquid cryogen and the right liquid cryogen space 1203 is meant for downwards flowing liquid cryogen. A partition wall 1204 separates the two liquid cryogen spaces from each other. The partition wall 1204 comprises solid material rendered into its final form in an additive manufacturing process. The material has a surface-to-volume ratio of at least 10⁵ 1/m.

The large surface-to-volume ratio has been achieved by making the material of the partition wall define a recursive spatial form of the kind described above. In cross-section it has a stepwise zig-zag form, a characteristic dimension of which is d1. The first partial enlargement shows how a section that in the larger drawing looks like a short straight line may actually have a stepwise zig-zag form, a characteristic dimension of which is d2 so that d2<d1. The second partial enlargement shows how a section that in the first partial enlargement looks like a short straight line may actually have a stepwise zig-zag form, a characteristic dimension of which is d3 so that d3<d3, and so on. The recursively smaller spatial forms can be repeated to smaller and smaller portions of the materials for as long as the spatial resolution of the additive manufacturing method allows.

The stepwise zig-zag form shown 12 is only a simplified graphical example of recursive spatial forms that the material of the partition wall 1204 may define. A large number of recursive spatial forms suitable for this purpose are known from three-dimensional fractal geometry. It is a known property of fractals that their characteristic dimension (total length in the case of a two-dimensional fractal curve; total area in the case of three-dimensional fractal surface) can be made arbitrarily large by increasing the degree of recursion. As a consequence, by applying the principle explained here the surface-to-volume ratio of the heat exchanger material can be made very large, and at least larger than 10⁵ 1/m.

The principles shown in figs. 3 to 11 and those shown in fig. 12 may be combined, for example so that the principle of recursive spatial forms shown in fig. 12 can be applied down so a certain level, which is not yet close to the spatial resolution of the additive manufacturing method. The surface of a material so formed may then be further covered with surface structures that follow the principles described above with reference to figs. 3 to 11.

Figs. 13 to 17 show some non-limiting examples of heat exchangers that may comprise one or more of the heat exchanger materials described above. The heat exchanger 1301 of fig. 13 has an inner liquid cryogen space 1302 and an outer liquid cryogen space 1303. A partition wall 1304 separates the inner and outer liquid cryogen spaces 1302 and 1303 from each other. The partition wall 1304 is at least partly made of a heat exchanger material of the kind described above. The heat exchanger 1401 of fig. 14 has a left liquid cryogen space 1402 and a right liquid cryogen space 1403. A partition wall 1404 separates the left and right liquid cryogen spaces 1402 and 1403 from each other. The partition wall 1404 is at least partly made of a heat exchanger material of the kind described above.

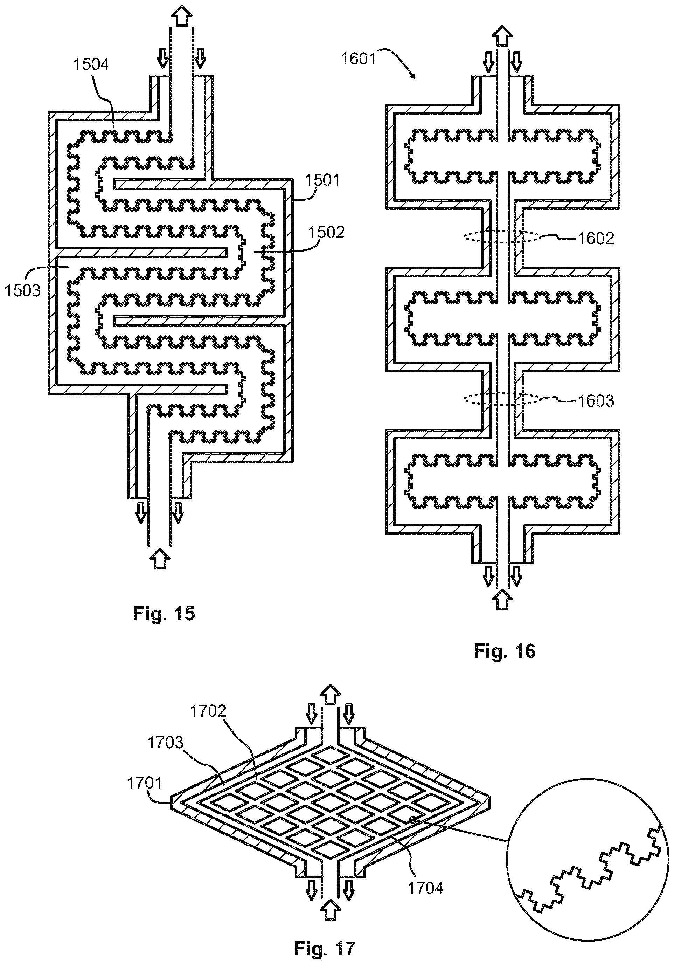

The heat exchanger 1501 of fig. 15 has an inner liquid cryogen space 1502 and an outer liquid cryogen space 1503. A partition wall 1504 separates the inner and outer liquid cryogen spaces 1502 and 1503 from each other. The partition wall 1504 is at least partly made of a heat exchanger material of the kind described above. The heat exchanger 1601 of fig. 16 consists of three heat exchangers like that in fig. 13 connected in series, so that flow restrictors 1602 and 1602 regulate the flow of liquid cryogens between the stages of the heat exchanger 1601.

Fig. 17 illustrates a heat exchanger 1701 with an inner channel system 1702 intertwined with an outer channel system 1703. At least some of the partition walls 1704 that separate the inner and outer channel systems may comprise heat exchanger material of the kind described above.

One or more additive manufacturing methods may be used to manufacture parts of heat exchangers like those described in the examples above. In particular, one or more additive manufacturing methods may be used to manufacture those parts the material of which has a surface-to-volume ratio of at least 10⁵ 1/m. One or more additive manufacturing methods can also be used to manufacture the whole heat exchanger, in particular in cases like fig. 17 where the shapes included in the heat exchanger are so complicated that they would be difficult or impossible to manufacture with more conventional manufacturing methods.

Heat exchangers like those described in the examples above can be used in a cryogenic cooling system. Such a system comprises one or more flow paths for a liquid cryogen. Along said one or more flow paths, one or more heat exchangers may be used to transfer thermal energy to or from a liquid cryogen flowing through said one or more flow paths. The one or more heat exchangers may comprise solid material rendered into its final form in an additive manufacturing process. At least a surface layer of said final form of the material may have a surface-to-volume ratio of at least 10⁵ 1/m. Such solid material is exposed to liquid cryogen on a flow path in order to utilize the advantageous characteristics of the material that have been described above.

It is obvious to a person skilled in the art that with the advancement of technology, the basic idea of the invention may be implemented in various ways. The invention and its embodiments are thus not limited to the examples described above, instead they may vary within the scope of the claims.

## Claims

1. Heat exchanger material for use in heat exchangers of cryogenic cooling systems, **characterized in that**:
- the material comprises solid material rendered into its final form in an additive manufacturing process, and
- the material has a surface-to-volume ratio of at least 10⁵ 1/m.

2. A heat exchanger material according to claim 1, **characterized in that** the material comprises a plurality of extended thermal conduction paths in the form of regularly shaped portions of said solid material that extend through a majority of a thickness of the material and occur in a repetitive pattern throughout a layer of said material.

3. A heat exchanger material according to claim 1 or 2, **characterized in that** the material has a recursive surface structure in which surface features of first characteristic dimension are covered with similar surface features of second characteristic dimension smaller than said first characteristic dimension.

4. A heat exchanger material according to any of claims 1 to 3, **characterized in that** said material defines a recursive spatial form in which first spatial features of a piece of said material have a first characteristic dimension and consist of second, similar spatial features of a second characteristic dimension smaller than said first characteristic dimension.

5. A heat exchanger material according to any of claims 1 to 4, **characterized in that** said at least one surface of the material comprises a maze defined by a plurality of mesh-formed or matrix-formed layers stacked on top of a solid surface of said material, at least some of said mesh-formed or matrix-formed layers having solid stretches that bridge openings in a respective adjacent mesh-formed or matrix-formed layer.

6. A heat exchanger material according to any of claims 1 to 5, wherein said solid material comprises at least one of: copper, silver, plastic.

7. Heat exchanger for transferring thermal energy to or from a liquid cryogen, **characterized in that** the heat exchanger comprises a surface of a liquid cryogen space and, as a part of said surface, solid material rendered into its final form in an additive manufacturing process, at least a surface layer of said final form of the material having a surface-to-volume ratio of at least 10⁵ 1/m.

8. A heat exchanger according to claim 7, comprising a base structure that limits said liquid cryogen space and a multitude of protrusions extending from said base structure into said liquid cryogen space, so that said surface of said liquid cryogen space comprises surfaces of said protrusions.

9. Heat exchanger according to claim 8, wherein said multitude of protrusions constitute a recursively repeating branching structure based on each individual protrusion of at least said majority of protrusions.

10. Heat exchanger according to any of claims 7 to 10, wherein said solid material comprises a maze defined by layered meshes or particle matrices on said surface of the base structure.

11. Heat exchanger according to claim 7, wherein said maze is defined by layers of mesh or particle matrix on top of each other with a lateral shift between consecutive ones of said layers of mesh or particle matrix.

12. Heat exchanger according to claim 7, comprising a liquid cryogen vessel divided into at least two separate liquid cryogen spaces by a partition wall, so that said surface of said liquid cryogen space comprises at least one surface of said partition wall.

13. A cryogenic cooling system comprising:
- a flow path for a liquid cryogen and
- along said flow path at least one heat exchanger for transferring thermal energy to or from a liquid cryogen flowing through said flow path;
wherein said at least one heat exchanger comprises solid material rendered into its final form in an additive manufacturing process, at least a surface layer of said final form of the material having a surface-to-volume ratio of at least 10⁵ 1/m,
and wherein said solid material is exposed to liquid cryogen on said flow path.
